# EUROPÄISCHE PATENTSCHRIFT

(11) **EP 1 003 234 B1**
(45) Veröffentlichungstag und Bekanntmachung des Hinweises auf die Patenterteilung: **03.01.2007**
(21) Anmeldenummer: 99121224.2
(22) Anmeldetag: 23.10.1999
(51) Int. Cl.: H01M 10/48, G01R 19/00

(54) **Verfahren und Anordnung zur Ermittlung der Leerlaufspannung einer Batterie**
Method and apparatus for the determination of the open-circuit voltage of a battery
Procédé et appareillage pour la détermination de la force électromotrice à circuit ouvert d'une batterie

(30) Priorität: 17.11.1998 DE 19852917
(43) Veröffentlichungstag der Anmeldung: 24.05.2000
(73) Patentinhaber: ROBERT BOSCH GMBH, 70442 Stuttgart (DE)
(72) Erfinder: Etzold, Peter, 73061 Ebersbach (DE); Kutteruf, Karl-Martin, 73272 Neidlingen (DE)

(56) Entgegenhaltungen:
- EP-A- 0 022 450
- EP-A- 0 355 461
- DE-A- 2 043 660
- GB-A- 2 232 495
- US-A- 5 703 469

## Beschreibung

### Stand der Technik

Die Erfindung geht aus von einem Verfahren zur Ermittlung der Leerlaufspannung einer Batterie gemäß der im Oberbegriff des Anspruchs 1 definierten Gattung, sowie von einer Anordnung gemäß dem Oberbegriff des Anspruchs 6.

Zur Ermittlung der Leerlaufspannung einer Batterie ist es üblich und allgemein bekannt, Spannungsmeßgeräte zu verwenden, die hochohmig sind und von einer eigenen oder einer fremden Spannungsversorgung versorgt werden.

Aufgabe der Erfindung ist die Angabe eines Verfahrens zur Ermittlung der Leerlaufspannung einer Batterie sowie zur Angabe einer Anordnung zur Durchführung dieses Verfahrens, bei dem ein anderer Weg gegangen wird und bei dem das Meßgerät nicht von einer eingebauten Spannungsversorgung oder von einer Fremdspannungsquelle versorgt wird, sondern aus der zu überprüfenden Batterie selbst. Dabei tritt allerdings das Problem auf, daß durch die Belastung, die das Meßgerät auf die Batterie bringt, die Messung der Leerlaufspannung verfälscht wird.

### Vorteile der Erfindung

Das erfindungsgemäße Verfahren zur Ermittlung der Leerlaufspannung einer Batterie mit den kennzeichnenden Merkmalen des Anspruchs 1 hat demgegenüber die Vorteile, die Messung der Leerlaufspannung auf einfache, schnelle und zuverlässige Weise durchführen zu können, wobei auf eine Fremdversorgung oder Eigenversorgung des Meßgerätes verzichtet werden kann. Dadurch ist es in der Handhabung wesentlich einfacher. Das erfindungsgemäße Verfahren erlaubt es in vorteilhafter Weise, daß trotz Speisung des Meßgerätes aus der zu überprüfenden Batterie selbst, die Leerlaufspannung dieser Batterie ermittelt wird und angezeigt werden kann.

Bei dem Verfahren gemäß der Erfindung erfolgt dazu prinzipiell die Ermittlung aus einer Spannung unter Last, wozu ein Spannungsmeßgerät an die Batterie angeschlossen und durch die Batterie, deren Leerlaufspannung ermittelt werden soll, mit Betriebsstrom versorgt wird. Eine erste Spannungsmessung wird nach Ablauf einer gewissen Anschaltzeit durchgeführt und nach Ablauf einer weiteren bestimmten Zeitspanne wird eine zweite Spannungsmessung bei einer durch einen Teststrom erhöhten Belastung durchgeführt. Aus der ermittelten Spannungsdifferenz der beiden Spannungsmessungen unter Last wird die Leerlaufspannung ermittelt.

Durch die in den weiteren Ansprüchen niedergelegten Merkmale sind vorteilhafte Weiterbildungen und Verbesserungen des im Anspruch 1 angegebenen Verfahrens möglich.

Entsprechend einer besonders zweckmäßigen und vorteilhaften Ausgestaltung des erfindungsgemäßen Verfahrens ist der Wert des Teststromes so groß gewählt, wie es dem Wert des Betriebsstromes entspricht.

In weiterer vorteilhafter Ausgestaltung des erfindungsgemäßen Verfahrens sind die Zeitspannen, nach denen die erste Spannungsmessung und nach denen die zweite Spannungsmessung nach der Belastungserhöhung durch den Teststrom durchgeführt werden, gleich groß gewählt.

In weiterer vorteilhafter und sehr zweckmäßiger Ausgestaltung des erfindungsgemäßen Verfahrens wird die Leerlaufspannung ermittelt als die Summe des Spannungswerts, der bei der ersten Spannungsmessung ermittelt wird, und der Differenz des Spannungswertes, der bei der ersten Spannungsmessung ermittelt wird, und des Spannungswertes, der bei der zweiten Spannungsmessung ermittelt wird.

In vorteilhafter Weise und Ausgestaltung des erfindungsgemäßen Verfahrens wird dieses mittels eines Mikroprozessors gesteuert durchgeführt. Dadurch ist eine große Flexibilität in der Anpassung und Durchführung gegeben und möglich.

Eine besonders zweckmäßige Anordnung zur Durchführung des Verfahrens nach der Erfindung bzw. seinen entsprechenden Ausgestaltungen besteht darin, daß als Spannungsmeßgerät ein Batterie-Tester vorgesehen ist, der einen Mikroprozessor enthält, mit welchem der Testablauf gesteuert wird, und daß der Batterie-Tester so gestaltet ist, daß er seinen Betriebsstrom von der zu testenden Batterie erhält.

In weiterer zweckmäßiger Ausgestaltung dieser Anordnung ist vorgesehen, daß der Batterie-Tester eine Anzeige enthält, die den ermittelten Wert der Leerlaufspannung der getesteten Batterie anzeigt.

Die Erfindung wird nachfolgend anhand eines Ausführungsbeispieles und der Zeichnung näher erläutert, in der
- Fig. 1: schematisch den Strom- und Spannungsverlauf beim Verfahren gemäß der Erfindung zur Ermittlung der Leerlaufspannung an einer Batterie angibt, und
- Fig. 2: in einem vereinfachten Blockschaltbild das Ersatzschaltbild einer Batterie und einen daran angeschlossenen Batterie-Tester schematisch zeigt.

### Beschreibung des Ausführungsbeispieles

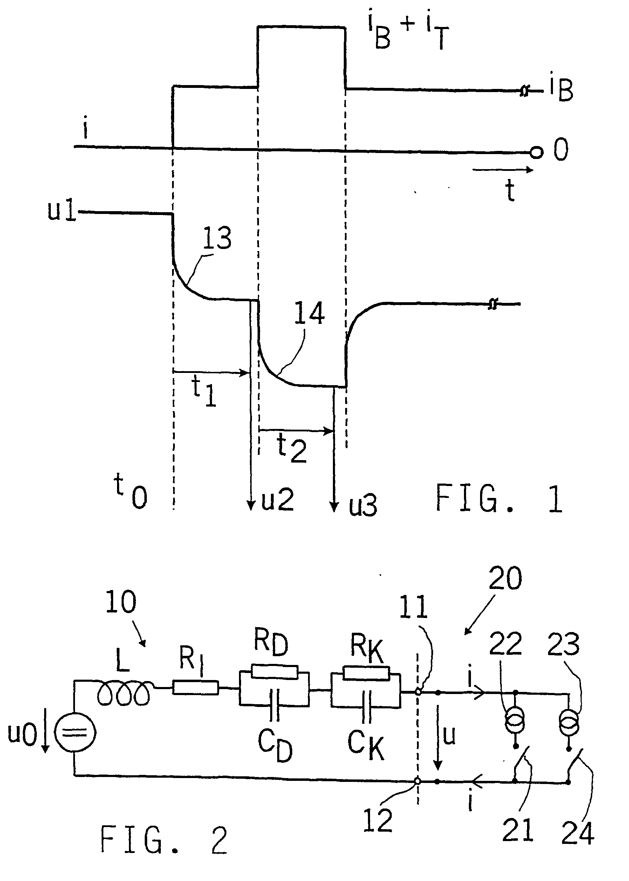

Anhand des Diagrammes in Fig. 1, das schematisch den Strom- und Spannungsverlauf beim Durchführen des erfindungsgemäßen Verfahrens zur Ermittlung der Leerlaufspannung einer Batterie zeigt, und anhand der Fig. 2, in der die Batterie mit einem Ersatzschaltbild dargestellt ist, und der Batterie-Tester ebenfalls in vereinfachter Weise mit einem Ersatzschaltbild dargestellt ist, wird der Ablauf des erfindungsgemäßen Verfahrens dargestellt und erläutert.

Entsprechend dem erfindungsgemäßen Verfahren, dessen zeitlicher Ablauf anhand des Stromes i und der Spannung u in Fig. 1 in zeitlicher Abhängigkeit über der Zeitachse t dargestellt ist, erfolgt der Ablauf folgendermaßen: Nach dem Einschalten des Spannungsmeßgerätes zum Zeitpunkt tₒ fließt durch das Spannungsmeßgerät ein Betriebsstrom i_{B}, wodurch der Spannungswert von der Leerlaufspannung u₁ entlang der Kurve 13 abfällt. Nach Ablauf einer bestimmten Zeit t₁ nach dem Einschalten des Spannungsmeßgerätes 20 wird die erreichte Spannung u₂ gemessen. Kurz nach dieser Spannungsmessung wird zu dem Betriebsstrom i_{B} ein Teststrom i_{T} hinzugeschaltet, so daß nunmehr die Batterie verstärkt belastet wird. Nach Ablauf einer weiteren Zeitspanne t₂ wird die dann erreichte Spannung u₃ gemessen. Nach dieser Spannungsmessung kann der Teststrom wieder auf Null gefahren werden, so daß nur noch der Betriebsstrom i_{B} vom Meßgerät gezogen wird. Der Abfall vom Spannungswert u₂ auf den Spannungswert u₃ erfolgt entlang des Astes 14 der Spannungskurve in Fig. 1, der ähnlich verläuft wie der Spannungsast 13. Dieser Verlauf ist im wesentlichen als exponentiell anzusehen.

Aus den gemessenen Spannungswerten u₂ und u₃ zu den bestimmten Meßzeiten t₁ nach der Einschaltung t₀ und t₂ nach der Erhöhung des Betriebsstroms i_{B} durch den Teststrom i_{T} wird die Leerlaufspannung u₁ der Batterie 10 ermittelt. Die Leerlaufspannung u₁ wird ermittelt als die Summe des Spannungswertes u₂, der bei der ersten Spannungsmessung ermittelt wird, und der Differenz des Spannungswertes u₂, der bei der ersten Spannungsmessung ermittelt wird, und des Spannungswertes u₃, der bei der zweiten Spannungsmessung ermittelt wird, wobei die Gleichung gilt, u₁ = u₂ + (u₂ - u₃).

Die Ermittlung der Leerlaufspannung u₁ hat sich als besonders einfach dann erwiesen, wenn die Größe des Teststroms i_{T} gleich dem Wert des Betriebsstroms i_{B} ist, d.h. i_{T} = i_{B}, und wenn die Zeiträume, nach denen jeweils gemessen wird, gleich sind, d.h. t₁ = t₂. Oder mit anderen Worten, die erste Messung erfolgt nach Ablauf der gleichen Zeitspanne, wie die zweite Messung nach Hinzuschalten des Teststroms.

Das in Fig. 2 dargestellte Ersatzschaltbild einer Batterie 10 enthält die Spannungsquelle u₀ und die Reihenschaltung einer Induktivität L und eines ohmschen Innenwiderstands R_{I}, sowie in Reihe damit die Parallelschaltung eines ohmschen Widerstandes R_{D} und eines Kondensators C_{D} sowie in Reihe dazu eine weitere Parallelschaltung eines ohmschen Widerstandes R_{K} und eines Kondensators C_{K}. An die Klemmen 11 und 12 der Batterie 10 wird der Batterie-Tester 20 angeschlossen.

Zwischen den Klemmen 11 und 12 liegt die interessierende Leerlaufspannung u₁ der Batterie 10 an. Allerdings nur dann, wenn der Batterie-Tester 20 nicht belastend angeschlossen ist. Die für das erfindungsgemäße Verfahren wesentlichen Teile des Batterie-Testers 20 sind in dem Ersatzschaltbild in Fig. 2 dargestellt. Der Batterie-Tester 20 ist als Verbraucher selbst symbolisch mit dem Bezugszeichen 22 dargestellt, der durch den Schalter 21 zum Zeitpunkt t₀ an die Klemmen 11 und 12 der Batterie 10 angeschlossen wird. Die Zusatzbelastung für das Ziehen des Teststromes i_{T} ist durch einen Testverbraucher 23 dargestellt, der durch einen Schalter 24 dann zugeschaltet wird, wenn die zweite Meßperiode t₂ zu laufen anfängt und der Belastungsstrom durch den Batteriestrom i_{B} und den Teststrom i_{T} gebildet wird. Kurz nach Beendigung der zweiten Messung für die Spannung u₃ wird der Schalter 24 wieder geöffnet, so daß die Batterie 10 nicht zusätzlich durch den Testverbraucher 23 unnötig belastet wird. Nicht dargestellt ist in Fig. 2 der Mikroprozessor, der vorteilhafterweise den erfindungsgemäßen Ablauf steuert und im Batterie-Tester 20 untergebracht ist.

Das in Fig. 2 dargestellte Ersatzschaltbild der Batterie 10 gilt insbesondere für die spezielle Anwendung des erfindungsgemäßen Meßverfahrens an Kraftfahrzeug-Starterbatterien. Dabei ist mit folgenden Größen zu rechnen: Der Betriebsstrom i_{B} des Batterie-Testers 20, der als Spannungsmeßgerät dient, beträgt etwa 0,4 A. Zweckmäßigerweise wird der Teststrom i_{T} ebenfalls mit 0,4 A gewählt. Die Zeitspannen t₁ und t₂, nach denen die Messungen nach Fließen des Betriebsstromes i_{B} bzw. des erhöhten Stromes i_{B} + i_{T} durchgeführt werden, also die Zeitspannen t₁ und t₂ werden zu etwa 0,5 Sekunden gewählt. Für die Werte u₁, u₂ und u₃ ergeben sich nach der oben genannten Gleichung dabei folgende Werte u₁ ≈ 12,2 V, u₂ ≈ 12,18 V und u₃ ≈ 12,16 V.

Für die einzelnen Komponenten des in Fig. 2 dargestellten Ersatzschaltbildes der Batterie 10, was eines von vielen möglichen Ersatzschaltbildern ist, ergeben sich für eine 36Ah-Batterie in etwa folgende Werte: Die Induktivität L beträgt etwa 0,17 µH, der ohmsche Innenwiderstand R_{I} ungefähr 10 mΩ, der ohmsche Doppelschichtwiderstand R_{D} ungefähr 2,5 mΩ, die Doppelschichtkapazität C_{D} ungefähr 10 F, das ohmsche Konzentrationselement R_{K} ungefähr 220 mΩ und die zugehörige Kapazität C_{K} ungefähr 20 · 10³F. Da der Batterie-Tester 20 den Ladezustand des Kondensators C_{K} nicht kennt, weil die Vorgeschichte der Batterie ja unbekannt ist, und die Zeitkonstante τ_{K} ungefähr 1,22 h beträgt, bleibt die innere Spannung u₀ verborgen. Man muß mehr als 12 Stunden warten, um u₀ sicher zu erfassen.

Die Elemente Rₖ, Cₖ und die daraus resultierende Zeitkonstante τ_{K} sind für den eigentlichen Testvorgang zur Ermittlung der Leerlaufspannung u₁ nicht wesentlich. Dies deswegen, weil der Testvorgang in weniger als 10 Sekunden abläuft. Als wesentlich sind die Elemente R_{D} und C_{D} mit der Zeitkonstante τ_{D} ≈ 25 ms, weil aus diesen die Werte für die Meßzeiten t₁ und t₂, insbesondere t₁ = t₂ so groß bzw. gleich groß gewählt sind, um dabei sicherzugehen, daß der Kondensator C_{D} geladen ist. Bei der Wahl von 0,5 Sekunden jeweils und einem τ_{D} von ungefähr 25 ms ist dies eindeutig gegeben.

Mit dem erfindungsgemäßen Verfahren und der Anordnung zu seiner Durchführung wird somit auf sehr einfache Weise und einfach zu handhabende Weise die Leerlaufspannung u₁ oder mit anderen Worten die Klemmenspannung einer Batterie ermittelt, die in lastfreiem Zustand anliegen würde. Die Ermittlung erfolgt jedoch nicht im lastfreien, sondern im belasteten Zustand der Batterie. Vorteilhaft ist, daß der Batterie-Tester selbst keine eigene Stromversorgung braucht, sondern aus der zu prüfenden Batterie gespeist wird. In vorteilhafter Ausgestaltung enthält der Batterie-Tester 20 eine Anzeige, die den erfindungsgemäß ermittelten Wert der Leerlaufspannung der getesteten Batterie anzeigt.

## Patentansprüche

1. Verfahren zur Ermittlung der Leerlaufspannung einer Batterie,
**dadurch gekennzeichnet, daß**
die Ermittlung aus einer Spannung unter Last erfolgt, wozu ein Spannungsmessgerät (20) an die Batterie (10) angeschlossen und durch die Batterie (10), deren Leerlaufspannung (u₁) ermittelt werden soll, mit Betriebsstrom (i_{B}) versorgt wird,
eine erste Spannungsmessung zur Messung eines ersten Spannungswertes (u₂) nach Ablauf einer gewissen ersten Anschaltzeit (t₁) durchgeführt wird,
nach Ablauf einer weiteren bestimmten Zeitspanne (t₂) eine zweite Spannungsmessung zur Messung eines zweiten Spannungswertes (u₃) bei einer durch einen Teststrom (i_{T}) erhöhten Belastung durchgeführt wird, und
aus der ermittelten Spannungsdifferenz der bei den Spannungsmessungen unter Last gemessenen Spannungswerte (u₂, u₃) die Leerlaufspannung (u₁) ermittelt wird.

2. Verfahren nach Anspruch 1, **dadurch gekennzeichnet, daß** der Wert des Teststromes (i_{T}) so groß gewählt ist, wie es dem Wert des Betriebsstroms (i_{B}) entspricht (i_{B} = i_{T}).

3. Verfahren nach Anspruch 1 oder 2, **dadurch gekennzeichnet, daß** die Zeitspannen (t₁, t₂), nach denen die erste Spannungsmessung zur Messung des ersten Spannungswerts (u₂) und nach denen die zweite Spannungsmessung (u₃) zur Messung des zweiten Spannungswerts nach der Belastungserhöhung durch den Teststrom (i_{B}) durchgeführt werden, gleich groß gewählt sind (t₁ = t₂).

4. Verfahren nach einem der Ansprüche 1 bis 3, **dadurch gekennzeichnet, daß** die Leerlaufspannung (u₁) ermittelt wird als die Summe des ersten Spannungswerts (u₂), der bei der ersten Spannungsmessung ermittelt wird, und der Differenz des ersten Spannungswerts (u₂), der bei der ersten Spannungsmessung ermittelt wird, und des Spannungswerts (u₃), der bei der zweiten Spannungsmessung ermittelt wird, gemäß der Gleichung u₁ = u₂ + (u₂ - u₃).

5. Verfahren nach einem der Ansprüche 1 bis 4, **dadurch gekennzeichnet, daß** es mittels eines Mikroprozessors gesteuert durchgeführt wird.

6. Anordnung zum Durchführen des Verfahrens nach Anspruch 1 oder einem der Ansprüche 2 bis 5, **dadurch gekennzeichnet, daß** als Spannungsmeßgerät ein Batterie-Tester (20) vorgesehen ist, der einen Mikroprozessor enthält, mit welchem der Testablauf gesteuert wird, und daß der Batterie-Tester (20) so gestaltet ist, daß er seinen Betriebsstrom (i_{B}) von der zu testenden Batterie (10) erhält.

7. Anordnung nach Anspruch 6, **dadurch gekennzeichnet, daß** der Batterie-Tester (20) eine Anzeige enthält, die den ermittelten Wert der Leerlaufspannung (u₁) der getesteten Batterie (10) anzeigt.

## Claims

1. Method for determination of the no-load voltage of a battery,
**characterized in that**
the determination is made from a voltage on load, for which purpose a voltmeter (20) is connected to the battery (10) and is supplied with operating current (i_{B}) by the battery (10) whose no-load voltage (u₁) is intended to be determined, a first voltage measurement is carried out in order to measure a first voltage value (u₂) after a specific first connection time (t₁) has elapsed,
a second voltage measurement is carried out in order to measure a second voltage value (u₃) with a load which has been increased by a test current (i_{T}), after a further specific time interval (t₂) has elapsed, and the no-load voltage (u₁) is determined from the determined voltage difference between the voltage values (u₂, u₃) measured during the voltage measurements on load.

2. Method according to Claim 1, **characterized in that** the value of the test current (i_{T}) is chosen to be sufficiently large that it corresponds (i_{B} = t_{T}) to the value of the operating current (i_{B}).

3. Method according to Claim 1 or 2, **characterized in that** the time intervals (t₁, t₂) after which the first voltage measurement is carried out in order to measure the first voltage value (u₂) and after which the second voltage measurement (u₃) is carried out in order to measure the second voltage value after the load has been increased by the test current (i_{B}), are chosen to be of equal duration (t₁ = t₂).

4. Method according to one of Claims 1 to 3,
**characterized in that** the no-load voltage (u₁) is determined as the sum of the first voltage value (u₂), which is determined during the first voltage measurement, and the difference between the first voltage value (u₂), which is determined during the first voltage measurement, and the voltage value (u₃) which is determined during the second voltage measurement, using the equation: u₁ = u₂ + (u₂ - u₃).

5. Method according to one of Claims 1 to 4,
**characterized in that** the method is carried out controlled by means of a microprocessor.

6. Arrangement for carrying out the method according to Claim 1 or one of Claims 2 to 5, **characterized in that** a battery tester (20) is provided as the voltmeter and contains a microprocessor by means of which the test procedure is controlled, and **in that** the battery tester (20) is designed such that it receives its operating current (i_{B}) from the battery (10) to be tested.

7. Arrangement according to Claim 6, **characterized in that** the battery tester (20) has a display which indicates the determined value of the no-load voltage (u₁) of the tested battery (10).

## Revendications

1. Procédé pour la détermination de la force électromotrice à circuit ouvert d'une batterie,
**caractérisé en ce qu'**
on effectue la détermination à partir d'une tension sous charge, en branchant sur la batterie (10) un appareil de mesure de tension (20) alimenté en courant de fonctionnement (i_{B}) par l'intermédiaire de la batterie (10) dont la force électromotrice à circuit ouvert (u₁) doit être déterminée,
on effectue une première mesure de tension pour avoir une première valeur de la tension (u₂) après écoulement d'un certain premier temps de mise en conduction (t₁),
après écoulement d'un autre laps de temps déterminé (t₂), ont effectue une seconde mesure de tension pour avoir une seconde valeur de la tension (u₃) sous une charge accrue par un courant d'essai (i_{T}), et
on détermine la force électromotrice à circuit ouvert (u₁) à partir de la différence existant entre les valeurs de la tension (u₂, u₃) mesurées sous charge lors des mesures de tension.

2. Procédé selon la revendication 1,
**caractérisé en ce que**
la valeur du courant d'essai (i_{T}) est choisie pour correspondre à la valeur du courant de fonctionnement (i_{B}) (i_{B} = i_{T}).

3. Procédé selon la revendication 1 ou 2,
**caractérisé en ce que**
les laps de temps (t₁, t₂) après lesquels on effectue la première mesure pour la première valeur de tension (u₂) et la seconde mesure pour la seconde valeur de tension (u₃) après augmentation de la charge par le courant d'essai (i_{B}), sont choisis identiques (t₁ = t₂).

4. Procédé selon l'une des revendications 1 à 3,
**caractérisé en ce que**
la force électromotrice à circuit ouvert (u₁) est déterminée par la somme de la première valeur de tension (u₂), lors de la première mesure de la tension, et de la différence entre la première valeur de tension (u₂) lors de la première mesure de tension et la valeur de tension (u₃) lors de la seconde mesure de tension, suivant l'équation u₁ = u₂ + (u₂ - u₃).

5. Procédé selon l'une des revendications 1 à 4,
**caractérisé en ce que**
celui-ci est effectué sous le contrôle d'un microprocesseur.

6. Appareillage pour la réalisation du procédé selon la revendication 1 ou l'une des revendications 2 à 5,
**caractérisé en ce que**
l'appareil de mesure de tension est un testeur de batterie (20) qui renferme un microprocesseur permettant de contrôler le déroulement du test, et le testeur de batterie (20) est conçu pour recevoir un courant de fonctionnement (i_{B}) qui provient de la batterie (10) à tester.

7. Appareillage selon la revendication 6,
**caractérisé en ce que**
le testeur de batterie (20) renferme un dispositif d'affichage indiquant la valeur déterminée de la force électromotrice à circuit ouvert (u₁) de la batterie testée (10).
